**Europäisches Patentamt**

**(19)** **European Patent Office**

**Office européen des brevets**

(11) Publication number: **0 004 148**
**B1**

(12) **EUROPEAN PATENT SPECIFICATION**

(45) Date of publication of patent specification: **04.11.81**

(21) Application number: **79300271.8**

(22) Date of filing: **21.02.79**

(51) Int. Cl.³: **H 01 L 23/48,**
**H 01 L 23/12,**
**H 01 L 23/30,**
**H 01 L 23/36, H 05 K 7/02**

(54) Electrical connector for use in mounting an electronic device on a substrate.

(30) Priority: **28.02.78 US 882300**

(43) Date of publication of application:
**19.09.79 Bulletin 79/19**

(45) Publication of the grant of the European patent:
**04.11.81 Bulletin 81/44**

(84) Designated Contracting States:
**BE DE FR GB IT NL SE**

(56) References cited:
**FR - A - 2 111 767**
**US - A - 3 271 507**

**IBM TECHNICAL DISCLOSURE BULLETIN, vol.
21, October 1978
New York, U.S.A.
J.D. LARNERD et al. "IC Package Assemblies"
pages 1817—1818**

(73) Proprietor: **AMP INCORPORATED**
**Eisenhower Boulevard**
**Harrisburg, Pennsylvania (US)**

(72) Inventor: **Andrews, Daniel Marshall**
**531 Shadow Hill Road**
**San Marcos California (US)**
Inventor: **Merlina, Joseph Francis**
**2454 Rudy Road**
**Harrisburg Pennsylvania (US)**
Inventor: **Redmond, John Peter**
**5213 Deerfield Avenue**
**Mechanicsburg Pennsylvania (US)**
Inventor: **Scheingold, William Samuel**
**R.D. No. 1, Box 260A**
**Palmyra Pennsylvania (US)**
Inventor: **Ulbrich, George**
**5120 Haverfort Road**
**Harrisburg Pennsylvania (US)**

(74) Representative: **Stuart-Prince, Richard Geoffrey**
**et al,**
**20 Queensmere**
**Slough, Berkshire SL1 1YZ (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Electrical connector for use in mounting an electronic device on a substrate

This invention relates to an electrical connector for use in mounting an electronic device on a substrate.

Known connectors for use in mounting electronic devices such as integrated circuit chips, on substrates such as printed circuit boards, comprise a housing moulded from electrically insulating material and carrying a plurality of electrical contacts each having a portion for contacting a lead on the electronic device, and a portion for receipt in a hole in a substrate or in a socket contact mounted on the substrate.

Other known connectors comprise a moulded housing adapted to receive and hold an electronic device in contact with conductors on a substrate, the housing being formed with latching members arranged to effect such holding.

Such known connectors suffer from the disadvantages that they are relatively large in size and also expensive to manufacture, these being particular disadvantages in view of the decreasing size and cost of electronic devices and particularly integrated circuit chips.

In French Patent Specification No. 2111767 there is disclosed such an electrical connector comprising a body formed from a sheet of electrically insulating material in open box configuration, and a plurality of mutually isolated metallic leads each extending across part of the base and a wall on the inner surface of the body, each lead terminating at its outer end in a pad for connection to a substrate.

For use of this known connector an electronic device is mounted in the body in electrical connection with the inner ends of the leads, whereafter the pads at the outer ends of the leads can be used to connect the assembly to further electrical circuitry.

A particular problem which arises with such electronic device and connector assemblies is that of heat dissipation, and in this known connector no particular measures are provided to overcome this problem.

The provision of heat sink members on which the electronic device is mounted is known, but none is provided in the known connector discussed above.

According to this invention such a known connector is characterised in that each lead and a supporting portion of the material forming the body extend beyond the edge of the associated wall of the body, and the extending portion of the material forming the body provides at its outer end a surface lying substantially in a plane parallel to the plane of the base of the body, the connection pad of each lead being on such surface, there being a central electrically isolated heat sink member on the inner surface of the base of the body to receive the electronic device connected to the leads, and a metallic heat dissipation layer substantially covering the outer surface of the base and walls of the body, and the portions of the leads extending beyond the edges of the walls of the body.

This invention will now be described by way of example with reference to the accompanying drawings in which:—

Figure 1 is a perspective view of one side of a connector according to this invention;

Figure 2 is a perspective view of the other side of the connector of Figure 1;

Figure 3 is a sectional view showing the connector of Figures 1 and 2 in use;

Figure 4 is a perspective view of one side of another connector according to this invention;

Figure 5 is a perspective view of the other side of the connector of Figure 4; and

Figure 6 is a sectional view showing the connector of Figures 4 and 5 in use.

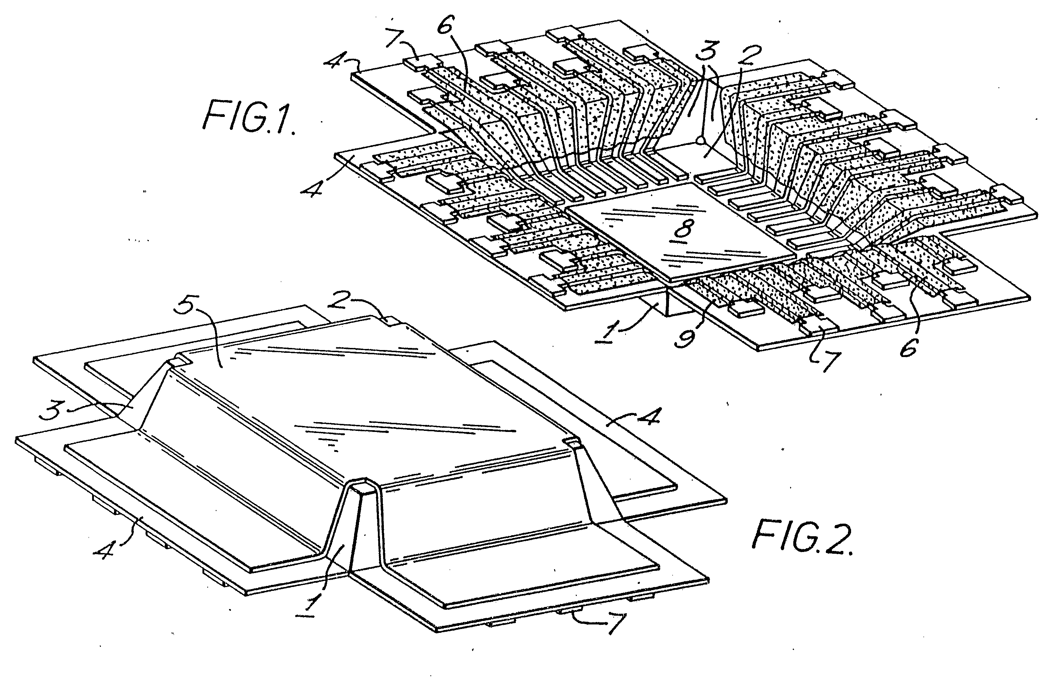

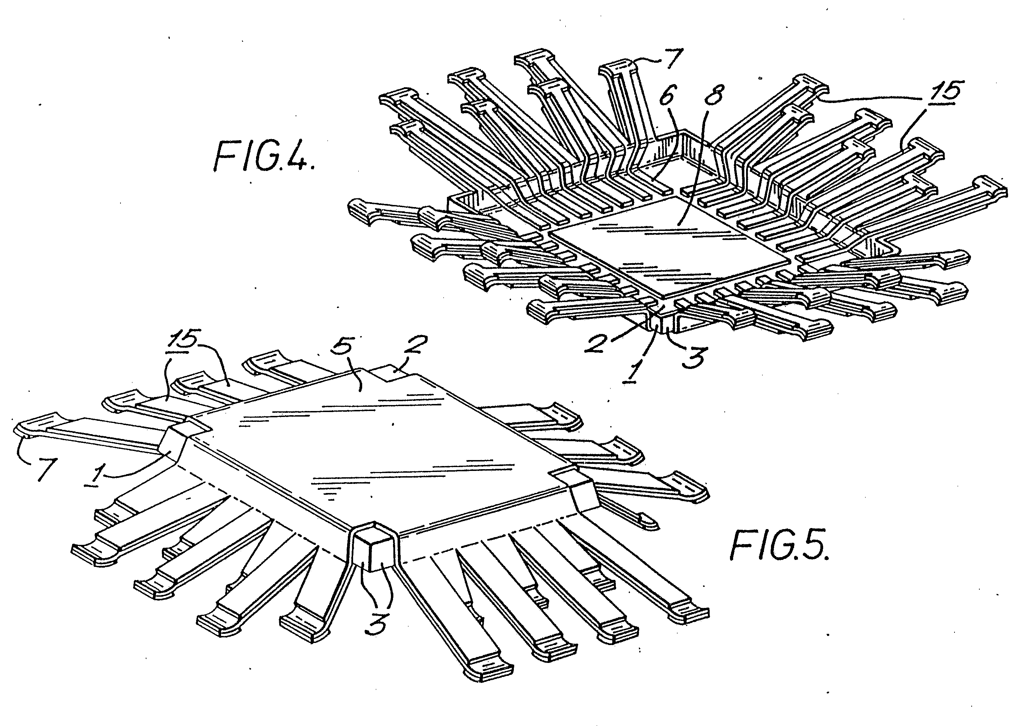

Referring to Figures 1, 2 and 3, the connector here shown comprises a body 1 formed from a sheet of electrically insulating material such as a glass-filled circuit board material 0.127 mm thick, in open box configuration, having a base 2 and walls 3. Each wall 3 terminates in an outwardly directed flange 4 lying in a plane parallel to the plane of the base 2.

A metallic layer 5, preferably of copper, extends over the base 2, walls 3 and flanges 4 on the outer surface of the body 1, while the inner surface of the body 1 carries a plurality of mutually isolated metallic leads 6 each extending across part of the base 2, a wall 3, and a flange 4 of the body, and terminating at its outer end in a pad 7. The leads 6 radiate from a central isolated metallic heat sink member 8 on the inner surface of the base 2 of the body 1.

The leads 6 are covered by a sheet 9 of electrically insulating material, leaving the pads 7 and a short length at the inner end of each lead 6 uncovered.

The above described structure is manufactured from an initially flat sheet of material to form the body 1, the sheet being provided with the metallic members 5, 6, 7 and 8 by conventional plating techniques prior to application of the sheet 9 and formation of the sheets and metallic members into the open box configuration with flanges shown in the drawings. To facilitate such formation the metallic layer 5 is cut away at positions which become corners of the body 1, as shown in Figure 2.

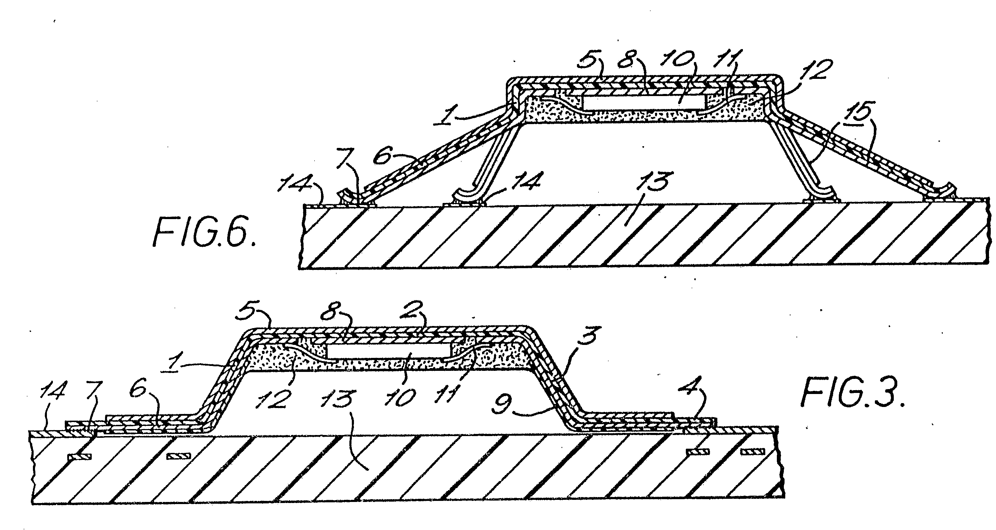

Referring now specifically to Figure 3, for use of the connector an integrated circuit chip 10 is bonded to the heat sink member 8 and contact areas on the chip 10 are connected to the inner ends of respective ones of the leads 6 by wires 11. The body 1 is then partially filled with an electrically insulating potting material 12 to a level which embraces the inner edges of the sheet 9 of insulating material. The connector with the chip 10 secured therein is then mounted on a substrate 13 by soldering or otherwise bonding the pads 7 on the leads 6 to conductors 14 on the substrate 13. During use the member 8 serves as a heat sink for the chip 10, and in view of the thinness of the body 1 the heat is conducted to the outer metallic layer 5 and radiated therefrom. In order to enhance such heat dissipation the sheet to form the body 1 can be formed with through holes (not shown) prior to application of the metallic members 5 and 8 such that the applied metal will fill the holes and provide direct metallic connections between the members 5 and 8.

Referring now to Figures 4, 5 and 6, the connector here shown is similar to that shown in Figures 1 to 3, and corresponding parts have been given the same reference numerals.

The essential difference in this connector is that the flanges 4 of the connector of Figures 1 to 3 and with them the overlying portions of the metallic layer 5, have been split into a plurality of fingers 15 each carrying one of the leads 6. Further, there is no insulating layer 9 covering the leads 6. The walls 3 of the body 1 are not as deep as those of the connector of Figures 1 to 3, and the fingers 15 do not extend therefrom parallel to the base 2, as do the flanges 4, but at angles to suit the spacing between the conductors 14 on the substrate 13.

The connector of Figures 4 to 6 has the further advantage that the fingers 15 are individually flexible and thus allow for differences in coefficients for thermal expansion between the connector and the substrate 13.

## Claims

1. An electrical connector for use in mounting an electronic device (10) on a substrate (13), comprising a body (1) formed from a sheet of electrically insulating material in open box configuration, and a plurality of mutually isolated metallic leads (6) each extending across part of the base (2) and a wall (3) on the inner surface of the body (1), each lead (6) terminating at its outer end in a pad (7) for connection to a conductor (14) on the substrate (13), characterised in that each lead (6), and a supporting portion of the material forming the body (1), extend beyond the edge of the associated wall (3) of the body (1), and the extending portion of the material forming the body provides at its outer end a surface lying substantially in a plane parallel to the plane of the base (2) of the body (1), the connection pad (7) of each lead (6) being on such surface, there being a central electrically isolated heat sink member (8) on the inner surface of the base (2) of the body (1) to receive the electronic device (10) connected to the leads (6), and a metallic heat dissipation layer (5) substantially covering the outer surface of the base (2) and walls (3) of the body (1), and the portions of the leads (6) extending beyond the edges of the walls (3) of the body (1).

2. A connector as claimed in Claim 1, characterised in that the portions of the material forming the body which extend beyond the edges of the walls (3) of the body (1) are in the form of a plurality of fingers (15) each carrying a portion of the outer metallic layer (5).

3. A connector as claimed in Claim 1, characterised in that each wall (3) of the body (1) over which leads (6) extend terminates in an outwardly directed flange (4) over which the portions of the leads (6) which extend beyond the walls (3) of the body (1) extend.

4. A connector as claimed in Claim 1, Claim 2 or Claim 3, characterised in that the leads (6) except for the pads (7) and a short length at the inner end of each lead (6), are covered by a sheet (9) of electrically insulating material.

5. A connector as claimed in any preceding claim, characterised by through holes in the base (2) of the body (1), which holes contain metal interconnecting the inner heat sink member (8) and the outer metallic layer (5).

## Revendications

1. Connecteur électrique destiné au montage d'un dispositif électronique (10) sur un substrat (13), comprenant un corps (1) formé à partir d'une feuille d'une matière électriquement isolante ayant la configuration d'une boîte ouverte, et plusieurs conducteurs métalliques (6) mutuellement isolés, chacun d'eux s'étendant sur une partie de la base (2) et sur une paroi (3) de la surface intérieure du corps (1), chaque conducteur (6) se terminant à son extrémité extérieure en un plot (7) destiné à la connexion avec un conducteur (14) se trouvant sur le substrat (13) caractérisé en ce que chaque conducteur (6) et une partie de support de la matière formant le corps (1) se prolongent au-delà du bord de la paroi associée (3) du corps (1), et la partie en prolongement de la matière formant le corps (1) définit à son extrémité extérieure une surface contenue pratiquement dans un plan parallèle au plan de la base (2) du corps (1), le plot de connexion (7) de chaque conducteur (6) se trouvant sur une telle surface, un radiateur central (8) électriquement isolé se trouvant sur la surface intérieure de la base (2) du corps (1) pour recevoir le dispositif électronique (10) connecté aux conducteurs (6), et une couche métallique de dissipation thermique (5) recouvrant pratiquement la surface extérieure de la base (2) et les parois (3) du corps (1), ainsi que les parties des conducteurs (6) se prolongeant au-delà des bords des parois (3) du corps (1).

2. Connecteur selon la revendication 1, caractérisé en ce que des parties des parties qui se prolongent au-delà des bords des parois (3) du corps (1) se présentent sous la forme de plusieurs doigts (15), chacun d'eux portant une partie de la couche métallique extérieure (5).

3. Connecteur selon la revendication 1, caractérisé en ce que chaque paroi (3) du corps (1) sur laquelle s'étendent les conducteurs (6) se termine par un rebord (4) dirigé vers l'extérieur, sur lequel s'étendent les parties des conducteurs (6) qui se prolongent au-delà des parois (3) du corps (11).

4. Connecteur selon la revendication 1, la revendication 2 ou la revendication 3, caractérisé en ce que les conducteurs (6), à l'exception des plots (7) et d'une courte longueur au niveau de l'extrémité intérieure de chaque conducteur (6), sont recouverts d'une feuille (9) d'une matière électriquement isolante.

5. Connecteur selon l'une quelconque des revendications précédentes, caractérisé par des trous traversants dans la base (2) du corps (1), ces trous contenant du métal qui interconnecte le radiateur intérieur (8) et la couche métallique extérieure (5).

## Patentansprüche

1. Elektrischer Verbinder zur Montage eines elektronischen Bauelements (10) auf einem Substrat (13), mit einem aus einer Platte elektrisch isolierenden Materials in Gestalt eines offenen Kastens geformten Körper (1) und einer Vielzahl von zueinander isolierten metallischen Leitungen (6), von denen sich jede über einen Teil der Basis (2) und einer Wand (3) auf der inneren Oberfläche des Körpers (1) erstreckt und jede Leitung (6) an ihrem äußeren Ende in einem Flecken (7) zur Verbindung mit einer Leitbahn (14) auf dem Substrat (13) endet, dadurch gekennzeichnet, daß jeder Leiter (6) und ein tragender Teil des den Körper (1) bildenden Materials sich über den Rand der zugeordneten Wand (3) des Körpers (1) hinaus erstreckt und der wegragende Teil des den Körper (1) formenden Materials an seinem äußeren Ende eine Fläche aufweist, die im wesentlichen in einer zur Ebene der Basis (2) des Körpers (1) parallelen Ebene liegt, daß der Verbindungsfleck (7) jedes Leiters (6) auf dieser Fläche angeordnet ist, daß ein zentrales, elektrisch isoliertes Wärmesenkenelement (8) auf der inneren Oberfläche der Basis (2) des Körpers (1) angeordnet ist, um das mit den Leitern (6) verbundene elektronische Bauelement (10) aufzunehmen, und daß eine metallische Wärmeableitungsschicht (5) im wesentlichen die äußere Oberfläche der Basis (2) und der Wände (3) des Körpers (1), sowie die sich über die Ränder der Wände (3) des Körpers (1) hinaus erstreckenden Teile der Leiter (6) bedeckt.

2. Verbinder nach Anspruch 1, dadurch gekennzeichnet, daß die Teile der sich über die Ränder der Wände (3) des Körpers (1) hinaus erstreckenden Teile in der Gestalt einer Vielzahl von Fingern (15) ausgebildet sind, von denen jeder einen Teil der äußeren metallischen Schicht (5) trägt.

3. Verbinder nach Anspruch 1, dadurch gekennzeichnet, daß jede Wand (3) des Körpers (1), über die sich Leiter (6) erstrecken, in einem auswärts gerichteten Flansch endet, über welchen sich die Teile der Leitungen (6), die sich über die Wände (3) des Körpers (1) hinaus erstrecken, erstrecken.

4. Verbinder nach einem der Ansprüche 1 bis 3, dadurch gekennzeichnet, daß die Leiter (6) mit Ausnahme der Flecken (7) und eines kurzen Stückes am inneren Ende jedes Leiters (6) von einer Platte (9) aus elektrisch isolierendem Material bedeckt sind.

5. Verbinder nach einem der vorhergehenden Ansprüche, dadurch gekennzeichnet, daß in der Basis (2) des Körpers (1) Löcher vorgesehen sind, die Metall enthalten, welches das innere Wärmesenkenteil (8) und die äußere metallische Schicht (5) verbindet.

FIG.1.

FIG.2.

FIG.4.

7

6 8 15

2 1 3

FIG.5.

15 5 2

7 1

3

0004148

FIG.6.

5  8  10  11  12

1

7  6

14  14  13  15

FIG.3.

5  8  2

1  3

14  7  6  12  13  10  11  9  4

0 004 148